# EUROPEAN PATENT APPLICATION

(11) **EP 0 849 873 A1**
(43) Date of publication of application: **24.06.1998**
(21) Application number: 97309441.0
(22) Date of filing: 24.11.1997
(51) Int. Cl.: H03D 7/16

(54) **Image-reject mixer arrangements**

(30) Priority: 18.12.1996 GB 9626229
(71) Applicant: PLESSEY SEMICONDUCTORS LIMITED, Swindon, Wiltshire SN2 2QW (GB)
(72) Inventor: Graham, Stephen Peter, Swindon, SN1 4BY (GB)
(74) Representative: Hoste, Colin Francis

(57) **Abstract**

In a mixer arrangement in which quadrature outputs from I and Q mixers are to be phase-shifted with respect to one another by a further 90°and summed, the phase shift circuits are current driven by respective differential transconductance amplifiers and the summing is carried out by cascode-connected summing transistors, to minimise the number of bias current paths required.

## Description

The present invention relates to image-reject mixer arrangements, and in particular although not exclusively to summing circuits for image-reject mixer arrangements.

In an image-reject mixer arrangement the quadrature output signals from I and Q mixers are shifted in phase relative to one another by a further 90° and summed, the "wanted" components of the I and Q output signals then being in phase and tending to reinforce one another and the image signals being out of phase and tending to cancel.

In known image-reject mixer arrangements the mixer, phase-shift and summing circuits are conventionally designed as discrete circuits each imposing its own bias current demands upon the energising supply. However, where such an arrangement is to form part of a miniaturised receiver, particularly a battery-powered receiver, it is desirable to keep current drain on the power source to a minimum.

According to a first aspect of the present invention, in an image-reject mixer arrangement in which quadrature I and Q output signals from I and Q mixers are arranged to be phase-shifted relative to one another by ninety degrees and summed, current signals corresponding to the I and Q output signals are arranged to be applied by way of respective current mode phase shift circuits to at least one cascode-connected current combining circuit.

According to a second aspect of the present invention, in an image-reject mixer arrangement, quadrature I and Q output signals from respective mixers are arranged to be applied by way of respective balanced transconductance amplifiers and respective current mode phase shift circuits to at least one cascode-connected current combining circuit.

According to a third aspect of the present invention, an image-reject mixer arrangement comprises, in respect of output signals from each of an I mixer and a Q mixer, an emitter-coupled pair of amplifier transistors to the base electrodes of which the output signals from the respective mixer are applied in antiphase, a current mode phase shifter and a pair of current combining transistors, the collector electrodes of the transistors of each pair of amplifier transistors being connected by way of the respective phase shifter to the emitter electrodes of the respective pair of current combining transistors and the collector electrodes of one pair of current combining transistors being connected to respective ones of the collector electrodes of the other pair of current combining transistors.

According to a fourth aspect of the present invention, an image-reject mixer arrangement comprises, in respect of output signals from each of an I mixer and a Q mixer, an emitter-coupled pair of amplifier transistors to the base electrodes of which the output signals from the respective mixer are applied in antiphase, and a current mode phase shifter having first and second outputs, the collector electrodes of the transistors of each pair of amplifier transistors being connected by way of the respective phase shifter to the emitter electrodes of a pair of current combining transistors, the emitter electrode of each transistor of said current combining pair of transistors being connected to an output of each of said phase shifters.

A monolithically formed image-reject mixer arrangement in accordance with any of the above aspects may have a lowermost plate of at least one phase shifter capacitor connected to the emitter electrode of a or the respective current combining transistor.

Image-reject mixer arrangements in accordance with the present invention will now be described by way of example with reference to the accompanying drawings, of which:-
Figure 1 shows schematically an image-reject mixer arrangement,
Figure 2 shows diagrammatically a conventional phase shift network,
Figure 3 shows diagrammatically a conventional circuit arrangement for image-reject mixing,
Figure 4 shows diagrammatically a first image-reject mixer arrangement in accordance with the present invention,
Figure 5 shows diagrammatically a current mode phase shift network as used in the arrangement of Figure 4, and
Figure 6 shows diagrammatically a second image-reject mixer arrangement in accordance with the present invention.

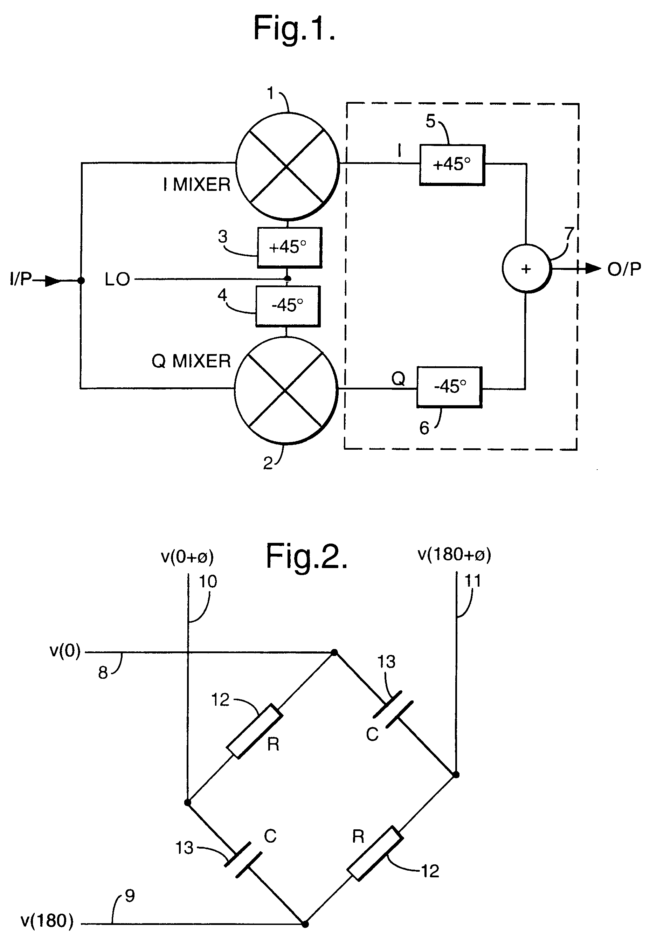

Referring first to Figure 1, in a mixer arrangement incorporating I and Q mixers 1 and 2 the local oscillator signals applied to the two mixers are arranged to be in quadrature, for example by utilising respective phase shifters 3 and 4 to shift the phase of signals from a common local oscillator source by plus and minus 45°. If the I and Q output signals are then shifted in phase relative to one another by a further 90°, for example by means of respective plus and minus 45° phase shifters 5 and 6, and added in a summing circuit 7, the signal components of the "wanted" sideband from the two output signals tend to reinforce one another while the signal components of the "image" sideband tend to cancel.

The phase-shift network shown in Figure 2 receives balanced, i.e. antiphase, signals at inputs 8 and 9 and provides signals at outputs 10 and 11 which are also in antiphase but which are shifted in phase relative to the signals at the inputs 8 and 9 in a sense and by an amount determined by the values of the resistors 12 and the capacitors 13.

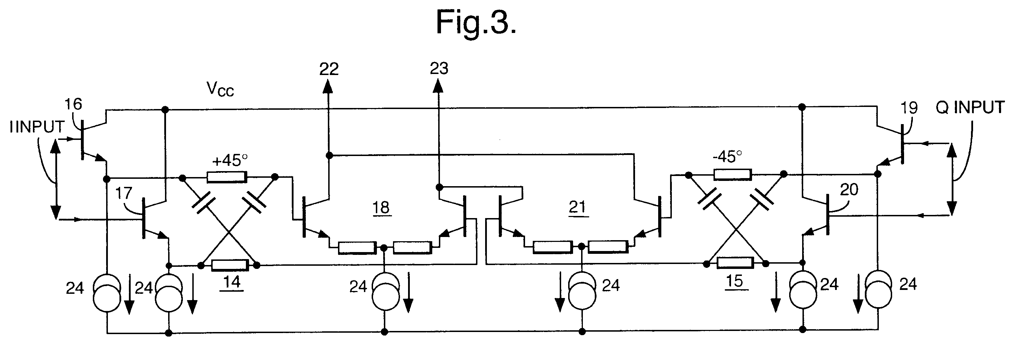

Two such phase shift networks 14 and 15 may be utilised as shown in Figure 3, where antiphase I-channel signals applied by way of emitter-follower circuits 16 and 17 are shifted in phase by plus 45° and passed to an emitter-coupled pair of transistors 18, and antiphase Q-channel signals applied by way of emitter-follower circuits 19 and 20 are shifted in phase by minus 45° and passed to another emitter-coupled pair of transistors 21. Current output signals from the collector electrodes of the transistor pairs 18 and 21 are added at outputs 22 and 23.

In the cascade-connected circuit arrangement of Figure 3 each of the emitter followers 16, 17, 19 and 20, and the emitter-coupled pairs 18 and 21 requires its own current source 24.

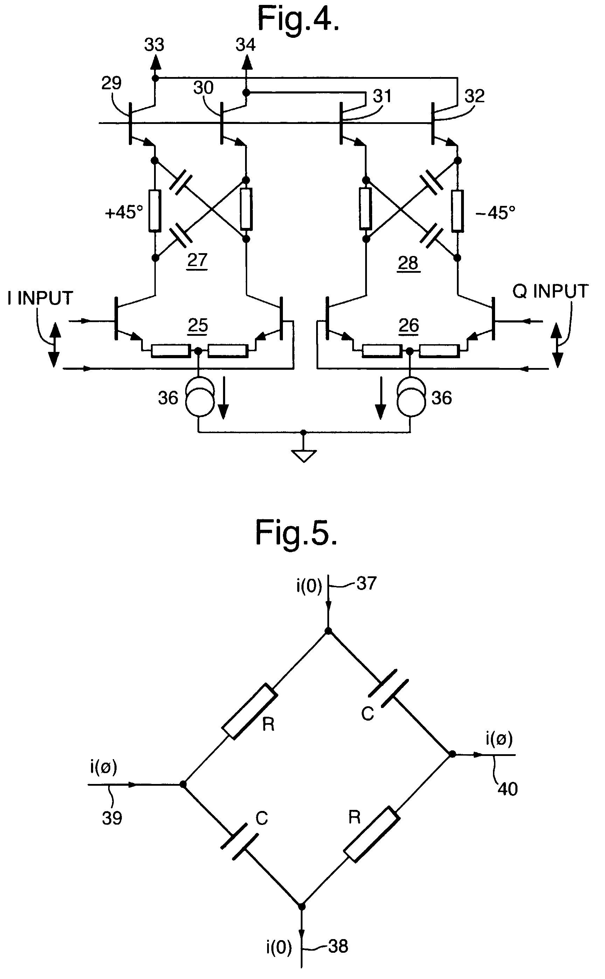

Referring now to Figure 4 in an image-reject mixer arrangement in accordance with the present invention, antiphase I and Q-channel signals are applied to respective emitter-coupled transistor pairs 25 and 26 respectively. Current signals from the collector electrodes of these transistor pairs are shifted in phase by plus 45° and minus 45° by respective current mode phase shift networks 27 and 28 and then summed at outputs 33, 34 connected to the collector electrodes of transistors 29, 32 and transistors 30, 31 respectively. Transistors 29 and 30 are connected respectively in cascode with the transistors of pair 25, and transistors 31 and 32 are connected respectively in cascode with the transistors of pair 26, a bias potential being applied to the base electrodes of the transistors 29 to 32 over a common path 35. Only two current sources 36 are required, one for each emitter-coupled pair 25, 26, so the present circuit arrangement draws less current from the energising supply (not shown) than the circuit arrangement of Figure 3.

Figure 5 illustrates a phase shift network for operation in current mode, the network being essentially similar to the voltage-mode network of Figure 2. In the arrangement shown in Figure 4 nodes 37 and 38 would be connected respectively to the collector electrodes of the transistors of a pair 25 or 26, while nodes 39 and 40 would be connected respectively to the emitter electrodes of transistors 29 and 30 or 31 and 32.

It has been found to be advantageous, when the arrangement is implemented monolithically as an integrated circuit on a semiconductor substrate, to connect each of the capacitors of the phase shifters 27, 28 so that their lowermost plate, which, being closest to the substrate, is the main cause of substrate parasitics, is connected to the emitter electrode of their associated combining transistor 29-32. In this way, the effects of the parasitics are minimised because the voltages experienced at these nodes are smaller than those experienced at the nodes between the transistor pairs 25, 26 and the phase shifters 27, 28 due to the low input impedance of those emitters. This results in improved linearity.

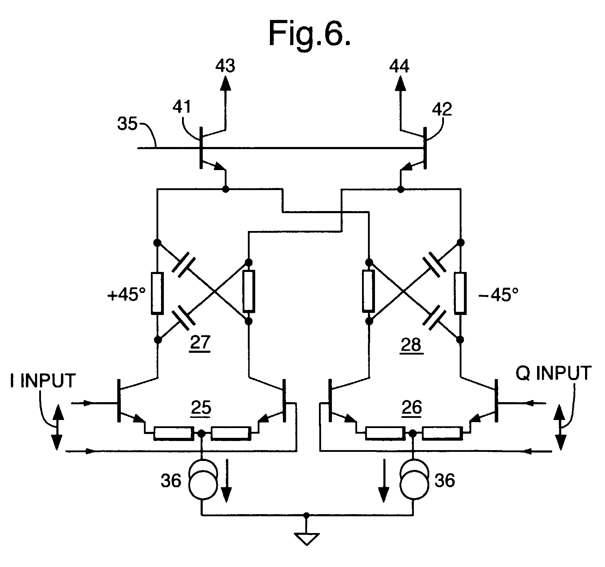

Referring now to Figure 6 in a second image-reject mixer arrangement in accordance with the present invention, antiphase I and Q channel signals are applied to respective emitter-coupled transistor pairs 25 and 26 respectively. Current signals from the collector electrodes of these transistor pairs are subsequently shifted in phase by plus 45° and minus 45° by respective current mode phase shift networks 27 and 28. The arrangement thusfar described is the same as that shown in Figure 4, from which reference numerals have been retained for like elements. In the present circuit arrangement, current summation is performed at the emitter electrodes of summing transistors 41 and 42. The transistors 41, 42 are able to perform the desired summation in this way because their input impedance, defined by their emitter impedance, is substantially lower than the output impedance of the phase shift networks 27, 28. The transistors 41, 42 do still however present a high impedance with output signals provided on outputs 43 and 44 because it is defined by the collector impedance of these transistors 41, 42. Transistors 41 and 42 are connected in cascode with transistors of both pairs 25 and 26, a bias potential being applied to the base electrodes of the transistors 41 and 42 over a common path 35. As with the Figure 4 arrangement, only two current sources 36 are required, one for each emitter-coupled pair 25, 26, so the present circuit arrangement draws less current from the energising supply (not shown) than the circuit arrangement of Figure 3.

Here, as with the Figure 4 arrangement, it has been found to be advantageous to connect the lowermost plate of each monolithically formed capacitor of the phase shifters 27, 28 to the emitter electrode of their associated combining transistor 41, 42.

## Claims

1. An image-reject mixer arrangement in which quadrature I and Q output signals from I and Q mixers are arranged to be phase-shifted relative to one another by ninety degrees and summed, wherein current signals corresponding to the I and Q output signals are arranged to be applied by way of respective current mode phase shift circuits to at least one cascode-connected current combining circuit.

2. An image-reject mixer arrangement wherein quadrature I and Q output signals from respective mixers are arranged to be applied by way of respective balanced transconductance amplifiers and respective current mode phase shift circuits to at least one cascode-connected current combining circuit.

3. An image-reject mixer arrangement comprising, in respect of output signals from each of an I mixer and a Q mixer, an emitter-coupled pair of amplifier transistors to the base electrodes of which the output signals from the respective mixer are applied in antiphase, a current mode phase shifter and a pair of current combining transistors, the collector electrodes of the transistors of each pair of amplifier transistors being connected by way of the respective phase shifter to the emitter electrodes of the respective pair of current combining transistors and the collector electrodes of one pair of current combining transistors being connected to respective ones of the collector electrodes of the other pair of current combining transistors.

4. An image-reject mixer arrangement comprising, in respect of output signals from each of an I mixer and a Q mixer, an emitter-coupled pair of amplifier transistors to the base electrodes of which the output signals from the respective mixer are applied in antiphase, and a current mode phase shifter having first and second outputs, the collector electrodes of the transistors of each pair of amplifier transistors being connected by way of the respective phase shifter to the emitter electrodes of a pair of current combining transistors, the emitter electrode of each transistor of said current combining pair of transistors being connected to an output of each of said phase shifters.

5. A monolithically formed image-reject mixer arrangement in accordance with any preceding Claim in which a lowermost plate of at least one phase shifter capacitor is connected to the emitter electrode of a or the respective current combining transistor.
